Europäisches Patentamt

European Patent Office

Office européen des brevets

(19)

(11) Numéro de publication : **0 084 393**
**B1**

# (12) FASCICULE DE BREVET EUROPÉEN

(45) Date de publication du fascicule du brevet :
**16.04.86**

(21) Numéro de dépôt : **83200040.0**

(22) Date de dépôt : **12.01.83**

(51) Int. Cl.⁴ : **H 01 L 29/80**, H 01 L 29/10,
H 01 L 29/36

(54) **Dispositif semiconducteur du genre transistor à hétérojonction(s).**

(30) Priorité : **18.01.82 FR 8200682**

(43) Date de publication de la demande :
**27.07.83 Bulletin 83/30**

(45) Mention de la délivrance du brevet :
**16.04.86 Bulletin 86/16**

(84) Etats contractants désignés :
**DE FR GB IT NL**

(56) Documents cités :
**EP-A- 0 027 761**
**EP-A- 0 033 876**
**EP-A- 0 042 489**
**EP-A- 0 051 504**
**EP-A- 0 067 276**
**DE-A- 2 847 451**
**IBM TECHNICAL DISCLOSURE BULLETIN, vol. 22,
no. 7, décembre 1979, page 2952, New York (US); C.A.
CHANG et al.: "GaSb-InAs-GaSb p-n-p Heterojunction
transistors for ultra-high speeds"**
**MICROELECTRONICS JOURNAL, vol. 13, no. 4, juil-
let-août 1982, pages 5-14, Kirkcaldy (GB) ; H. BENE-
KING et al.: "Medium-power GaAs bipolar transistors"**

(73) Titulaire : **Laboratoires d'Electronique et de Physique
Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB IT NL**

(72) Inventeur : **Frijlink, Peter Michael**
**Société Civile S.P.I.D. 209 rue de l'Université**
**F-75007 Paris (FR)**

(74) Mandataire : **Gendraud, Pierre et al**
**Société Civile S.P.I.D. 209, rue de l'Université**
**F-75007 Paris (FR)**

Jouve, 18, rue St-Denis, 75001 Paris, France

## Description

L'invention concerne un dispositif semiconducteur, du genre transistor à hétérojonction(s), comprenant un empilement de couches semiconductrices qui, par combinaison, forment trois régions dites de source, de grille et de drain, alors que le trajet de courant qui s'établit entre lesdites régions de source et de drain est sensiblement perpendiculaire aux diverses jonctions.

L'invention a trait aux dispositifs semiconducteurs, plus spécifiquement aux transistors à hétérojonction(s).

Les structures à hétérojonction(s) sont bien connues de l'art antérieur comme ayant été conçues et expérimentées dans les années 1950 et suivantes. Mais, bien que présentant des caractéristiques potentielles très intéressantes, supérieures à celles des homojonctions, elles ont été très peu développées sauf peut-être dans les dispositifs opto-électroniques, tels que les lasers. Ainsi, bien que de nombreux travaux et publications aient été rendus publics sur les dispositifs semiconducteurs à hétérojonction(s), les principales applications développées sur le marché sont du type à homojonction(s).

Une des raisons de ce faible développement des dispositifs à hétérojonction(s) provient de la mauvaise qualité cristalline et électronique des couches au niveau des interfaces, du fait des procédés de croissance utilisés alors, et il en résulte notamment une recombinaison importante des porteurs de charges aux interfaces.

Les nouveaux procédés de croissance développés depuis, tels que par exemple l'épitaxie en phase vapeur par la méthode des organo-métalliques, l'épitaxie par faisceau moléculaire et autres ont permis de réduire dans une large mesure les susdits inconvénients, et notamment d'améliorer la raideur des transitions et la liberté de choix des configurations des bandes de conduction.

De ce fait, les dispositifs semiconducteurs à hétérojonction(s) retrouvent la place qui leur est due, et le nombre des demandes de brevet déposées sur ce sujet en porte témoignage.

Un exemple récent de dépôt d'une demande de brevet sur un dispositif semiconducteur à hétérojonction est la demande de brevet européen EP-A-0 027 761, intitulée : « Dispositif semiconducteur à effet de champ, pour hautes fréquences, et transistor et dispositif à transfert de charges utilisant un tel dispositif semiconducteur », qui décrit un transistor de type horizontal, dont la région de grille comporte une jonction anisotype P/N (GaAs P/Ga$_{1-x}$Al$_x$AsN), dans lequel il apparaît une couche d'inversion de charges pour une polarisation positive de la région de grille.

Le dispositif semiconducteur selon la présente invention est constitué d'un empilement de couches semiconductrices formant par combinaison les trois régions de source, de grille et de drain, et le trajet de courant qui circule de la source au drain est sensiblement perpendiculaire aux diverses jonctions.

De tels dispositifs semiconducteurs à hétérojonction sont connus de l'art antérieur et l'on citera pour exemple le brevet US 4,119,994 qui décrit des transistors à hétérojonction(s) de type classique, c'est-à-dire dont une zone d'un premier type de conductivité (dite zone de base) est placée entre deux zones du second type de conductivité (dites zones d'émetteur et de collecteur).

Le dispositif semiconducteur selon la présente invention n'appartient pas à ce type de transistor ; c'est une nouvelle structure qui appartient à la famille des transistors, dans laquelle tous les transports de charges sont effectués par des électrons en étant des porteurs majoritaires. Le dispositif utilise à la fois le transport balistique ou quasi balistique pour le courant allant de la source au drain et la conduction dans un quasi-gaz de Fermi à deux dimensions pour la conduction dans la grille. Les porteurs du courant allant de la source au drain traversent ce gaz de Fermi perpendiculairement ou presque perpendiculairement sans avoir beaucoup d'interaction avec les porteurs qui constituent ledit gaz.

De nombreuses publications ont paru sur le transport balistique depuis au moins 1970, et l'on citera pour référence l'article dans IEEE Transactions on Electron Devices, Vol. ED-26, N° 11, Novembre 1979, intitulé : « Ballistic transport in semiconductor at low temperatures for low-power high-speed logic », par M.S. SHUR et L.F. EASTMAN.

Le gaz d'électrons à deux dimensions au voisinage d'une hétérojonction est par exemple décrit dans l'article de H.L. STORMER et al. intitulé : « Two dimensional electron gas at a semiconductor-semiconductor interface » qui a paru dans Solid State Communications, Vol. 29, p. 705-709, 1979.

Le dispositif semiconducteur selon la présente invention est remarquable en ce que la seconde région dite de grille est constituée d'une couche en un premier matériau semiconducteur, qui forme une première hétérojonction avec la couche immédiatement adjacente de la troisième région dite de drain, en un second matériau semiconducteur, alors que lesdits premier et second matériaux semiconducteurs sont choisis de telle sorte que, à l'hétérojonction, le niveau inférieur de la bande de conduction dans le premier matériau semiconducteur est situé en dessous du niveau inférieur de la bande de conduction dans le second matériau semiconducteur, et alors que, sous l'effet de la composante du champ électrique, normale à l'hétérojonction, il se forme dans la seconde région dite de grille, au voisinage de l'hétérojonction, une zone d'accumulation d'électrons constituant un quasi-gaz de Fermi à deux dimensions dans un puits de potentiel dont le niveau inférieur est commandé par une électrode de grille, et en ce que la première région, dite de source, comprend au moins une couche, dont au moins celle en contact avec l'électrode source est très fortement dopée de type n en un troisième matériau semiconducteur, choisi de telle sorte que le niveau inférieur de la bande de conduction dans le troisième matériau semiconducteur puisse, au moyen de la tension de polarisation qui y est appliquée, être rendu supérieur au niveau inférieur de la bande de conduction dans le second matériau semiconducteur, avec lequel le troisième matériau forme ainsi une seconde hétérojonction et en ce que ladite seconde région, dite de grille, est non dopée et plus mince que le libre parcours moyen des porteurs de charge de telle sorte que le transfert des électrons au travers de cette région s'effectue par effet balistique.

De cette manière, par suite d'une différence d'affinité électronique entre les premier et second matériaux semiconducteurs, des électrons libres sont transférés et s'accumulent dans le puits de potentiel qui s'est formé dans le premier matériau semiconducteur, au voisinage de l'hétérojonction, et constituent un quasi-gaz de Fermi à deux dimensions. La fonction de grille est alors réalisée de façon presque immatérielle par ce nuage d'électrons que l'on peut porter par une électrode au potentiel de polarisation désiré. Les électrons qui forment le courant source-drain traversent donc ce nuage d'électrons sans avoir beaucoup d'interaction avec lui.

D'autres variantes de réalisation apparaîtront mieux de la description qui va suivre en regard des dessins annexés, données à titre non limitatif, qui permettront de mieux comprendre comment l'invention s'exécute et se poursuit.

La figure 1 représente un dispositif selon l'art antérieur dont la structure et le fonctionnement sont les plus proches de l'invention.

La figure 2 représente un exemple de dispositif selon la présente invention.

Les figures 3 et 4 représentent les variations du dopage et du pourcentage en aluminium des diverses couches de Ga Al As/Ga As d'un exemple de dispositif selon l'invention.

La figure 5 représente de façon schématique le diagramme de bandes au voisinage de l'hétérojonction principale ;

et les figures 6a, 6b et 6c le diagramme de bandes de cette nouvelle hétérostructure, hors et en fonctionnement.

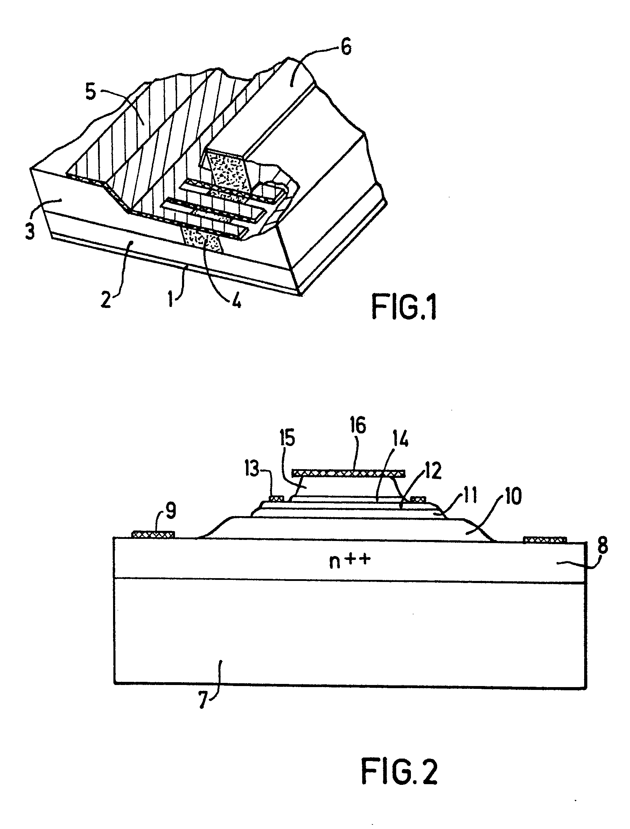

Le dispositif semiconducteur, selon l'art antérieur, tel que représenté à la figure 1, est tiré de l'article « Fabrication and Numerical Simulation of the Permeable Base Transistor », par C.O. BOZLER et G.D. ALLEY, dans IEEE Transactions on Electron Devices, Vol. ED-27, N° 6, Juin 1980. Un contact d'émetteur, référencé 1, de type ohmique, est pris sur une région fortement dopée, de type $n^+$, d'arséniure de gallium 2 ; le flux d'électrons émis par ce contact 1 est confiné par des régions isolantes 3, obtenu par exemple par un bombardement de protons, dans une région 4 normalement dopée de type n, et traverse ainsi une grille 5 formée d'une multitude de doigts noyés dans la matière semiconductrice pour atteindre enfin le contact de collecteur 6, également de type ohmique.

La grille 5 est formée par exemple par du tungstène qui réalise un contact de type Schottky, avec l'arséniure de gallium ; son rôle consiste à contrôler le flux d'électrons qui transitent de l'émetteur vers le collecteur, d'une façon quelque peu analogue à une triode dans le vide, malgré le rôle important joué par les courants de diffusion dans ce dispositif.

Avec un tel dispositif, la fréquence maximale de transition (le gain en courant est égal à l'unité) est définie d'une façon générale par la formule :

$$f_T = \frac{g_m}{2\,\pi C_T}$$

dans laquelle $g_m$ représente la transconductance et $C_T$ est calculé à partir de la variation totale de charge dans le semiconducteur $\Delta Q_T$, produite par une variation du potentiel de l'électrode de grille $\Delta V_{GS}$

$$C_T = \frac{\Delta Q_T}{\Delta V_{GS}}.$$

Les dispositifs réalisés selon ces enseignements présentent une fréquence maximale $f_T$, telle que définie précédemment, de l'ordre de 40 GHz. La fréquence de coupure ou fréquence maximale de fonctionnement est de l'ordre de 10 GHz.

Un dispositif selon la présente invention est représenté en une vue en coupe à la figure 2. Sur un substrat semi-isolant 7, tel que par exemple de l'arséniure de gallium, dopé au chrome, on fait croître par épitaxie une couche semiconductrice 8 fortement dopée, de type de conductivité $n^{++}$, avec un dopage de l'ordre de $10^{18}$ atomes . $cm^{-3}$ obtenu par exemple par introduction d'impuretés silicium et une épaisseur non critique, par exemple 0,5 micron. Cette couche 8 sert d'électrode de drain, et un contact ohmique 9, par exemple à partir d'un alliage or-germanium peut être pris sur le pourtour du dispositif, par exemple sous la forme d'une couronne.

Sur cette couche 8, très fortement dopée, on réalise une couche 10, faiblement dopée de type de conductivité n, avec un dopage par exemple de l'ordre de $10^{16}$ atomes · $cm^{-3}$, ou même non dopée, en un matériau semiconducteur tel que l'arséniure de gallium, d'une épaisseur voisine de 0,5 micron. Cette couche 10 a pour fonction essentielle de séparer la couche 8 des couches supérieures et par conséquent de diminuer la capacité entre l'électrode de drain formée par la couche fortement dopée 8 et le gaz de Fermi à deux dimensions qui fonctionne comme électrode de grille dans la couche 12 tout en augmentant aussi la tension de claquage drain-grille.

3

La couche 11 est une couche en un second matériau semiconducteur, par exemple en arséniure de gallium et d'aluminium $Ga_{1-x}Al_xAs$, d'une épaisseur de l'ordre de 100 nm. Cette couche 11 participe à la formation du puits de potentiel :

elle sert de barrière pour empêcher les électrons contenus dans le puits de potentiel de migrer vers le drain, sous l'effet du champ électrique ;

elle ne doit pas former une barrière pour les électrons provenant de la source, et sa hauteur est donc limitée de telle sorte que l'énergie cinétique de ces électrons lui soit supérieure ;

dans une variante particulière d'utilisation, il est possible d'utiliser cette barrière, pour moduler le nombre d'électrons en provenance de la source, qui arrive jusqu'au drain.

Selon une première réalisation de l'invention, cette couche 11 est composée de $Ga_{1-x}Al_xAs$, légèrement dopée n, avec une valeur fractionnelle en aluminium constante et suffisante. Selon une deuxième réalisation de l'invention, cette couche 11 est en fait formée de trois zones, avec au voisinage de la jonction avec la couche supérieure 12, une première zone non dopée d'une épaisseur voisine de 5 nm et une valeur fractionnelle x en aluminium qui varie continûment de 0.2 à 0.3 environ, puis une deuxième zone très fortement dopée, de type de conductivité $n^{++}$, avec un niveau de dopage de $10^{18}$ atomes . $cm^{-3}$, une épaisseur voisine de 10 nm et une valeur fractionnelle x en aluminium qui est constante à 0.3 environ, et enfin une troisième zone non dopée, d'une épaisseur voisine de 85 nm et une valeur fractionnelle en aluminium qui est constante à 0.3 environ, puis qui décroît en fin de zone jusqu'à devenir nulle, par exemple de façon linéaire.

Enfin, selon une troisième réalisation, cette couche 11 est non dopée, en arséniure de gallium et d'aluminium $Ga_{1-x}Al_xAs$ et une valeur fractionnelle x en aluminium variant par palier, comme dans la précédente réalisation.

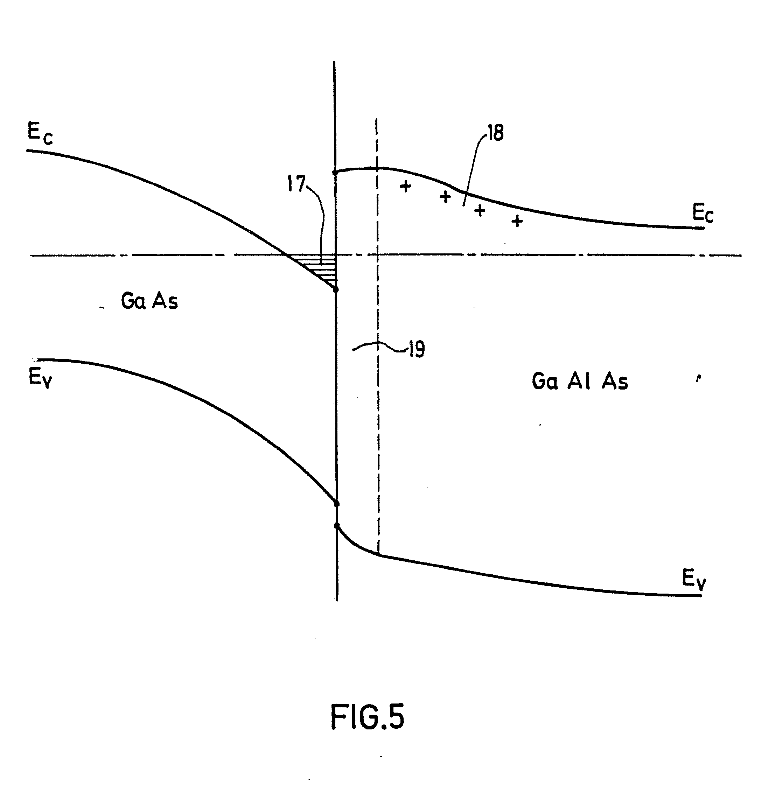

La couche 12 est une couche en un autre composé semiconducteur choisi de telle sorte que son niveau inférieur de la bande de conduction soit situé en dessous du niveau inférieur de la bande de conduction de la couche 11, et que sous l'effet de la composante du champ électrique, normale à l'hétérojonction entre les deux susdites couches 11/12, il s'y forme un puits de potentiel ; la courbure de la bande de conduction doit être suffisante pour que le niveau inférieur franchisse le niveau de Fermi au voisinage de l'hétérojonction, autorisant ainsi une accumulation d'électrons dans ce voisinage, ainsi que représenté à la figure 5 qui sera plus amplement commentée ci-après.

Selon une réalisation de l'invention, alors que la couche 11 est en arséniure de gallium et d'aluminium $Ga_{1-x}Al_xAs$, la couche 12 est en arséniure de gallium GaAs, non dopé.

Un exemple de choix possible pour les matériaux constituant les couches 11 et 12 est le couple GaAlAs/GaAs, mais d'autres matériaux sont possibles.

Cependant, compte tenu des connaissances et expérimentations sur ce sujet, la Demanderesse a retenu préférentiellement le couple GaAlAs/GaAs qui présente l'avantage d'une structure et d'une maille cristalline équivalentes, qui s'associe sans perturbation notable de l'ordre cristallin.

Dans cette couche 12, en GaAs non dopé, du fait de sa plus grande affinité électronique par rapport à la couche 11, en $Ga_{1-x}Al_xAs$, des électrons libres sont transférés et s'accumulent donc dans les plus bas niveaux d'énergie libres de toute occupation, compris entre le niveau inférieur de la bande de conduction et le niveau de Fermi. Cette zone d'enrichissement électronique occupe une épaisseur très faible, inférieure à 5 nm, dans une couche de GaAs d'épaisseur voisine de 50 nm, qui constitue ce qu'il convient d'appeler la région de grille de cette nouvelle structure. Le contact de grille, capable de commander le niveau de Fermi (ou quasi-niveau) de la susdite région de grille, est obtenu par une couche 13, en contact ohmique avec ladite couche 12 en GaAs, déposée par exemple sous la forme d'une couronne sur le pourtour de ce plateau intermédiaire, par exemple par un empilement d'une couche d'or sur une couche de germanium.

La région de source du nouveau dispositif est formée par l'ensemble des couches 14 et 15, sur laquelle une électrode de source 16 est déposée. La couche 14 est une couche intermédiaire entre la couche 15 qui sert de source d'électrons et les couches inférieures de la région de grille. La fonction essentielle de cette couche 14 est d'assurer aux électrons qui sortent de cette couche 14 et entrent dans la couche inférieure 12 de la région de grille, une énergie cinétique moyenne, dans le sens normal à l'interface des deux susdites couches 14/12, proche de la différence d'affinité électronique, entre les matériaux formant ces couches, dits troisième et premier matériaux semiconducteurs, pour respectivement les couches des régions de source et de grille.

Selon une réalisation de l'invention, la couche 14 est constituée d'arséniure de gallium et d'aluminium, non dopée, de faible épaisseur, par exemple 25 nm.

La couche 15, qui constitue la source d'électrons est également constituée d'arséniure de gallium et d'aluminium, mais très fortement dopée, de type n et de dopage supérieur à $10^{18}$ atomes . $cm^{-3}$, et d'une épaisseur non critique, par exemple de 200 nm. L'électrode de source est obtenue sous la forme d'un contact ohmique 16. Selon un exemple de réalisation, ce peut être réalisé sous la forme d'une couche d'arséniure de gallium, de type de conductivité n, dopé entre $10^{17}$ et $10^{18}$ atomes $\cdot cm^{-3}$, sur laquelle est déposée en faible épaisseur une couche de germanium de type de conductivité n, dopé par exemple par de l'arsenic, à $10^{20}$ atomes $\cdot cm^{-3}$, et sur laquelle est pris finalement un contact métallique, par exemple par dépôt d'or ou aluminium.

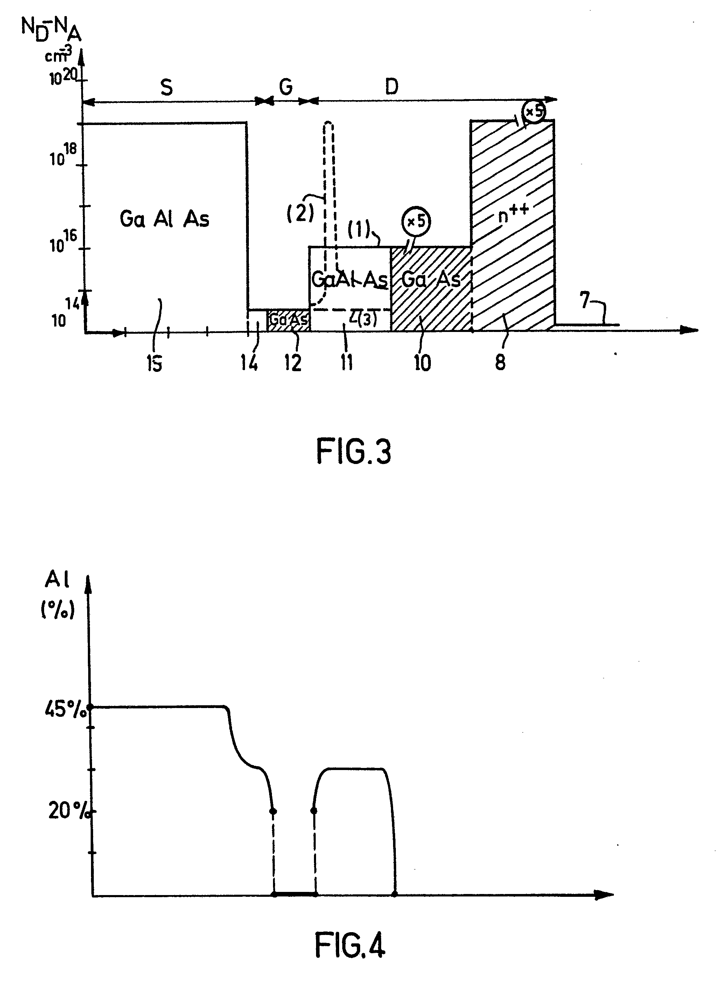

La figure 3 représente les variations du dopage en nombre d'atomes par centimètre cube. L'axe des

4

abscisses représente sensiblement l'épaisseur des couches (une unité = 50 nm) et l'axe des ordonnées le dopage, qui varie sensiblement depuis $10^{14}$ (semiconducteur intrinsèque) à $10^{19}$ atomes.cm$^{-3}$ (semiconducteur de type n$^{++}$). Le dopage de type de conductivité négatif des composés semiconducteurs GaAs et Ga$_{1-x}$Al$_x$As est effectué par exemple par des atomes d'impuretés comme le silicium (Si) ou le sélénium (Se). Le substrat est semi-isolant et obtenu par exemple par dopage au chrome (Cr) d'arséniure de gallium (GaAs). Les diverses zones de source, de grille et de drain sont également représentées sur cette figure par les symboles S, G et D. En outre, des courbes en pointillés représentent les diverses variantes de réalisation sus-citées.

La figure 4 représente les variations de la valeur fractionnelle x en aluminium, du composé Ga$_{1-x}$Al$_x$As, dans le cas de l'exemple de réalisation décrit avec le couple GaAs/GaAlAs. A partir d'une région de source, en plateau, avec une valeur de par exemple 0.45, on note une inflexion à environ 0.30 (couche 14) jusqu'à atteindre une valeur d'environ 0.20, inflexion correspondant à un changement dans la pente de la courbe qui représente les susdites variations. Symétriquement, une deuxième région en plateau, avec une valeur de par exemple 0.30 (couche 11) est atteinte, après une inflexion équivalente et symétrique à environ 0.20.

L'inflexion avec changement de pente des courbes de variation de la valeur fractionnelle x en aluminium du composé Ga$_{1-x}$Al$_x$As a pour but essentiel d'adoucir la courbure des niveaux de bande, à l'interface, de façon à diminuer le phénomène de réflexion quantique qui se produit lors du passage d'un électron à proximité d'une discontinuité de potentiel.

La figure 5 représente le schéma de bande, de part et d'autre de l'hétérojonction principale. La partie gauche du schéma représente le matériau GaAs, et la partie droite le matériau Ga$_{0.7}$Al$_{0.3}$As (à titre d'exemple). Dans un tel schéma, les symboles E$_c$ et E$_v$ représentent les niveaux inférieur et supérieur de la bande de conduction ou de valeur respectivement. Le symbole E$_f$ représente le niveau de Fermi, c'est-à-dire le niveau d'énergie pour lequel la probabilité d'occupation est égale à 0,5. Dans ce schéma, les courbures de bande sont telles qu'il apparaît une zone 17 d'accumulation d'électrons. Des électrons libres, en provenance de la région 18, de Ga$_{1-x}$Al$_x$As (dopé — Si) quittent celle-ci du fait de la différence d'affinité électronique des deux matériaux et viennent s'accumuler dans les plus bas niveaux d'énergie libre, donc dans cette mince région 17 proche de l'interface. Une mince couche 19, non dopée, dans le matériau Ga$_{1-x}$Al$_x$As est destinée à assurer une bonne séparation entre les impuretés donatrices (par exemple Si) et cette couche d'électrons localisés. Cette couche d'électrons localisés 17 forme une sorte de quasi-gaz de Fermi, à deux dimensions, alors que les moyens de polarisation 13 permettent de le porter au potentiel désiré, de l'ordre de quelques dixièmes de volts, par exemple 0,2 volt, par rapport à la source, et de commander ainsi le niveau inférieur du puits de potentiel. ·

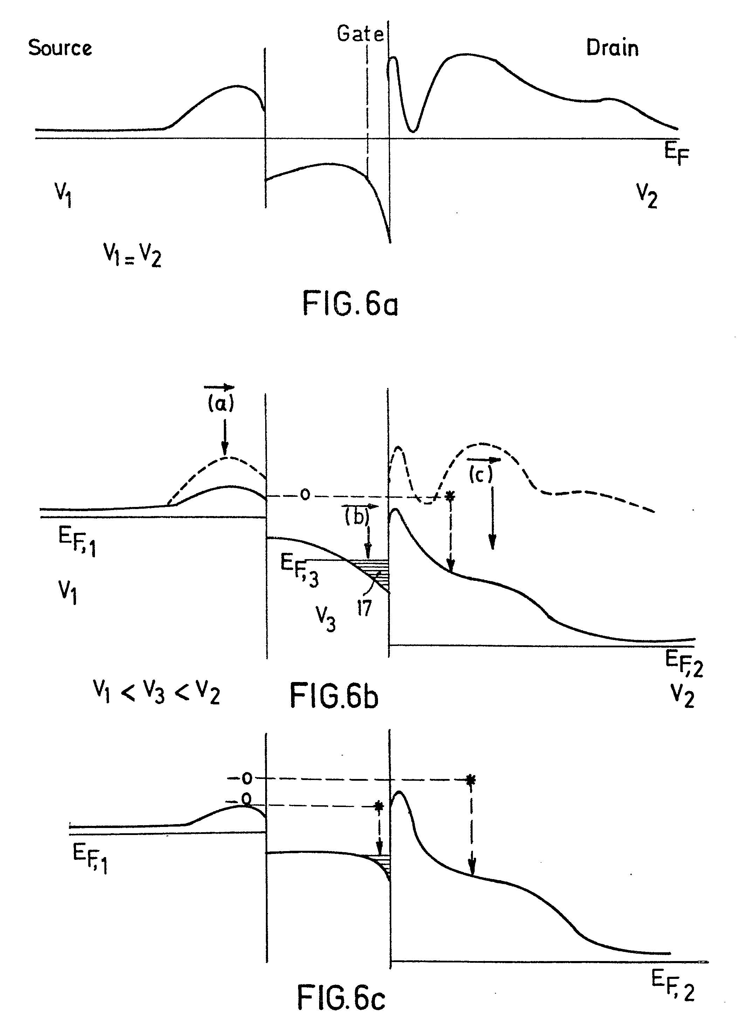

Enfin, la figure 6 représente les diagrammes de bande de l'ensemble du dispositif au même potentiel (figure 6-a) ou polarisé (figures 6-b et 6-c). Lorsque les deux matériaux sont au même potentiel $V_1 = V_2$, le schéma de bandes (figure 6-a) laisse apparaître un puits de potentiel, de telle sorte que le courant source-drain est nul. Lorsque les potentiels ne sont pas égaux, si $V_1 < V_2$, des électrons issus de la source peuvent franchir ce puits de potentiel.

En outre, alors que la région de grille est suffisamment mince et dépourvue d'impuretés, le transfert des électrons s'effectue au travers de cette région par effet balistique. Par « effet balistique », on entend dans le présent mémoire, que le porteur de charge, en l'espèce l'électron, est accéléré sans collision notable, ni avec les impuretés présentes dans le réseau cristallin, ni avec les phonons (vibrations du réseau) sur une distance inférieure à une longueur critique dite libre parcours.

A des températures de fonctionnement plus faibles, par exemple de l'ordre de 77 °K, où seul le phénomène de collision avec les impuretés est prépondérant (« impurity scattering »), le libre parcours moyen avant collision est plus important, par exemple de l'ordre du micron.

La figure 6-b représente le schéma de bandes lorsque le potentiel de source ($V_1$) est inférieur au potentiel de drain ($V_2$) et que le potentiel de grille ($V_3$) a une valeur intermédiaire :

$$V_1 < V_3 < V_2$$

L'effet sur le schéma de bandes de cette distribution de potentiels est le suivant : d'une part un écrasement (flèche $\overrightarrow{a}$) du premier pic de potentiel dans la région de source, d'autre part un basculement (flèche $\overrightarrow{b}$) du niveau de bande autour du quasi-niveau de Fermi dans le puits de potentiel de la région de grille, laissant apparaître une région d'accumulation d'électrons 17, enfin un abaissement (flèche $\overrightarrow{c}$) de l'ensemble de la courbe en dessous du niveau du premier pic de potentiel, dans la région de drain.

Le fonctionnement d'un tel dispositif apparaît alors simplement : des électrons libres, en provenance de la région de source quittent celle-ci par suite de la polarisation, franchissent la région de grille par effet balistique, et reviennent à l'état d'équilibre dans la région de drain, principalement par interaction avec une impureté (impurity scattering), cette interaction étant représentée par une étoile dans ce schéma.

Une partie α des électrons qui sont émis par la source à cause de la différence de potentiel entre source et grille, passe la région de la grille avec suffisamment de conservation d'énergie et d'impulsion pour que ces électrons franchissent la discontinuité dans la bande de conduction entre les régions de grille et de drain.

La valeur du courant d'électrons émis par la source est déterminée par la différence de potentiel entre source et grille. Le potentiel de la grille est fixé par le quasi-niveau de Fermi du gaz d'électrons à deux dimensions.

On peut distinguer deux modes d'opération du dispositif :

1) application comme FET : $\alpha \approx 1$. Le courant dans la grille est petit par rapport au courant du drain ;

2) $\alpha < 1$. Entre grille et source il y a une résistance négative. La figure 6-c schématise alors le schéma de bandes dans cette application, dans lequel une partie seulement des électrons peut franchir le puits de potentiel.

Son fonctionnement dans le premier cas peut rappeler celui d'une lampe à vide dans laquelle on trouve aussi un mouvement de porteurs de charges d'un seul signe (électrons), sous l'effet d'un champ électrique provoqué par la différence de potentiel établie entre une électrode d'émission (cathode) et une électrode de réception (plaque), courant modulé par le potentiel d'une électrode intermédiaire (grille).

Mais le dispositif, selon la présente invention, présente des propriétés autrement plus intéressantes que tous les dispositifs connus actuels, notamment en ce que la fréquence maximale de transition $f_T$, qui peut être approchée par la formule suivante :

$$f_T \sim \frac{1}{2\,\pi C_{GS}\,R_G}$$

est supérieure à 100 GHz.

**Revendications**

1. Dispositif semiconducteur, du genre transistor à hétérojonction(s), comprenant un empilement de couches semiconductrices qui, par combinaison, forment trois régions dites de source (15, 14), de grille (12) et de drain (11, 10, 8), alors que le trajet du courant qui s'établit entre lesdites régions de source et de drain est sensiblement perpendiculaire aux diverses jonctions, caractérisé en ce que la seconde région, dite de grille, est constituée d'une couche (12), en un premier matériau semiconducteur, qui forme une première hétérojonction avec la couche immédiatement adjacente (11) de la troisième région dite de drain, en un second matériau semiconducteur, alors que lesdits premier et second matériaux semiconducteurs sont choisis de telle sorte que, à l'hétérojonction, le niveau inférieur de la bande de conduction dans le premier matériau semiconducteur est situé en dessous du niveau inférieur de la bande de conduction dans le second matériau semiconducteur, et alors que, sous l'effet de la composante du champ électrique, normale à l'hétérojonction, il se forme dans la seconde région dite de grille, au voisinage de l'hétérojonction, une zone d'accumulation d'électrons constituant un quasi-gaz de Fermi à deux dimensions dans un puits de potentiel dont le niveau inférieur est commandé par une électrode dite de grille (13), et en ce que la première région, dite de source, comprend au moins une couche (15), dont au moins celle en contact avec l'électrode de source (16) est très fortement dopée de type n, en un troisième matériau semiconducteur choisi de telle sorte que le niveau inférieur de la bande de conduction dans le troisième matériau semiconducteur puisse, au moyen de la tension de polarisation qui y est appliquée, être rendu supérieur au niveau inférieur de la bande de conduction dans le second matériau semi-conducteur, avec lequel le troisième matériau forme ainsi une seconde hétérojonction et en ce que ladite seconde région, dite de grille, est non dopée et plus mince que le libre parcours moyen des porteurs de charge de telle sorte que le transfert des électrons s'effectue au travers de cette région par effet balistique.

2. Dispositif semiconducteur selon la revendication 1, caractérisé en ce que l'on choisit comme premier matériau semiconducteur de l'arséniure de gallium et comme second et troisième matériaux semiconducteurs de l'arséniure de gallium et d'aluminium.

3. Dispositif semiconducteur selon la revendication 2, caractérisé en ce que la troisième région dite de drain comporte, au moins, empilées sur un substrat semiconducteur (7), une couche (8) de GaAs, très fortement dopée $n^{++}$ avec un dopage de l'ordre de $10^{18}$ atomes · $cm^{-3}$, d'une épaisseur voisine de 0,5 micron, une couche (10) de GaAs, faiblement dopée n avec un dopage de l'ordre de $10^{16}$ atomes · $cm^{-3}$, ou même non dopée, d'une épaisseur voisine de 0,5 micron, et une couche (11) de $Ga_{1-x}Al_xAs$, dopée n d'une épaisseur voisine de 100 nm.

4. Dispositif semiconducteur selon la revendication 3, caractérisé en ce que la couche (11) de $Ga_{1-x}Al_xAs$ est faiblement dopée, de type de conductivité n, avec un dopage de l'ordre de $10^{16}$ atomes · $cm^{-3}$.

5. Dispositif semiconducteur selon la revendication 3, caractérisé en ce que la couche (11) de $Ga_{1-x}Al_xAs$ est en fait formée de trois zones, avec au voisinage de la couche supérieure (12), une première zone, non dopée, d'une épaisseur voisine de 5 nm et une valeur fractionnelle en aluminium qui varie continûment à partir d'un niveau de 0,20 environ jusqu'à 0,30, puis une deuxième zone, très fortement dopée, de type de conductivité $n^{++}$, avec un niveau de dopage supérieur à $10^{18}$ atomes · $cm^{-3}$, une épaisseur voisine de 10 nm et une valeur fractionnelle x en aluminium qui est constante à 0,30 environ et enfin une troisième zone non dopée, d'une épaisseur voisine de 85 nm et une valeur fractionnelle x en aluminium qui est constante à 0,30 environ, puis qui décroît en fin de zone jusqu'à devenir nulle.

6. Dispositif semiconducteur selon la revendication 3, caractérisé en ce que la couche (11) de $Ga_{1-x}Al_xAs$ est non dopée, et en ce que la valeur fractionnelle x en aluminium part d'un niveau de 0,20, atteint et reste constante à 0,30 sur une large partie de son épaisseur, puis décroît en fin de zone jusqu'à devenir nulle.

7. Dispositif semiconducteur selon la revendication 1 ou 2, caractérisé en ce que la seconde région, dite de grille, est constituée d'une couche (12) en GaAs, non dopée, alors que le contact de grille est obtenu par une couche (13) en contact ohmique avec ladite couche (12) en GaAs, non dopée.

8. Dispositif semiconducteur selon la revendication 7, caractérisé en ce que le contact de grille est obtenu par une couche (13), réalisée sous la forme d'une couche d'or sur une couche de germanium, formant un contact ohmique avec ladite couche (12) en GaAs, non dopée.

9. Dispositif semiconducteur selon la revendication 1, caractérisé en ce que la région de source est constituée d'une couche (14) en arséniure de gallium et d'aluminium, non dopée, d'une épaisseur de l'ordre de 25 nm, et d'une couche (15) également en arséniure de gallium et d'aluminium, de dopage supérieur à $10^{18}$ atomes $\cdot$ cm$^{-3}$, et d'une épaisseur de l'ordre de 200 nm, sur laquelle est pris un contact de source (16).

10. Dispositif semiconducteur selon la revendication 9, caractérisé en ce que le contact de source (16) est réalisé sous la forme d'une première couche d'arséniure de gallium de type n, de dopage compris entre $10^{17}$ et $10^{18}$ atomes $\cdot$ cm$^{-3}$, d'une deuxième couche de germanium, de type n, dopé par de l'arsenic à $10^{20}$ atomes $\cdot$ cm$^{-3}$ et d'une troisième couche métallique choisie dans le groupe formé par l'or et l'aluminium.

## Claims

1. A semiconductor device of the heterojunction transistor type comprising a stack of semiconductor layers, which form by combination three regions, i. e. the source region (15, 14), the gate region (12) and the drain region (11, 10, 8), while the path of the current flowing between the said source and drain regions is substantially at right angles to the various junctions, characterized in that the second region, i. e. the gate region, is constituted by a layer (12) of a first semiconductor material which forms a first heterojunction with the immediately adjacent layer (11) of the third region, i. e. the drain region, of a second semiconductor material, the said first and second semiconductor materials being chosen so that at the heterojunction the lower level of the conduction band in the rist semiconductor material is situated below the lower level of the conduction band in the second semiconductor material, while under the influence of the component of the electric field at right angles to the heterojunction in the second region, i. e. the gate region, near the heterojunction, there is formed a zone with an accumulation of electrons in a potential well whose lower level is controlled by a gate electrode (13), said zone constituting a two dimensional quasi Fermi gas, and in that the first (source) region comprises at least one layer (15) of a third semiconductor material, of which that layer which is in contact with the source electrode (16) is very highly n-doped, said third semiconductor material being chosen so that the lower level of the conduction band in the third semiconductor material can be made higher than the lower level of the conduction band in the second semiconductor material by means of the polarization voltage applied thereto, the third material thus forming a second heterojunction with the second semiconductor material, and in that the said second region, i. e. the gate region, is undoped and is thinner than the average free path length of the charge carrier in such a manner that the transfer of the electrons take place through this region by a ballistic effect.

2. A semiconductor device as claimed in Claim 1, characterized in that gallium arsenide is chosen at the first semiconductor material, while gallium aluminium arsenide is chosen as second and third semiconductor materials.

3. A semiconductor device as claimed in Claim 2, characterized in that the third region, i. e. the drain region, comprises in a stack on a semiconductor substrate (7) at least a layer (8) of GaAs very highly $n^{++}$ doped at a doping concentration of the order of $10^{18}$ atoms $\cdot$ cm$^{-3}$ and having a thickness of approximately 0.5 $\mu$m, a layer (10) of GaAs weakly n-doped at a doping concentration of the order of $10^{16}$ atoms $\cdot$ cm$^{-3}$ or even undoped and having a thickness of approximately 0.5 $\mu$m and a layer (11) of $Ga_{1-x}Al_xAs$ n-doped and having a thickness of approximately 100 nm.

4. A semiconductor device as claimed in Claim 3, characterized in that the layer (11) of $Ga_{1-x}Al_xAs$ is weakly doped, is of the n-conductivity type and has a doping concentration of the order of $10^{16}$ atoms $\cdot$ cm$^{-3}$.

5. A semiconductor device as claimed in Claim 3, characterized in that the layer (11) of $Ga_{1-x}Al_xAs$ is in fact formed from three zones, i. e. in the proximity of the upper layer (12) a first undoped zone having a thickness of approximately 5 nm and a fractional value for aluminium varying continually from a level of about 0.20 to 0.30, a second zone very highly $n^{++}$ doped at a doping level higher than $10^{18}$ atoms $\cdot$ cm$^{-3}$, and having a thickness of approximately 10 nm and a fractional value x for aluminium which is constant at about 0.30, and finally a third undoped zone having a thickness of approximately

85 nm and a fractional value x for aluminium which is constant at about 0.30 and decreases at the end of the zone until it becomes zero.

6. A semiconductor device as claimed in Claim 3, characterized in that the layer (11) of $Ga_{1-x}Al_xAs$ is undoped, and in that the fractional value x for aluminium initially is at a level of 0.20, reaches a level of 0.30 and remains constant at this level over a large part of its thickness and decreases at the end of the zone until it becomes zero.

7. A semiconductor device as claimed in Claim 1 or 2, characterized in that the second region, i. e. the gate region, is constituted by a layer (12) of undoped GaAs, while the gate contact is obtained by a layer (13) in ohmic contact with the said layer (12) of undoped GaAs.

8. A semiconductor device as claimed in Claim 7, characterized in that the gate contact is obtained by means of a layer (13) made in the form of a gold layer on a germanium layer forming an ohmic contact with the said layer (12) of undoped GaAs.

9. A semiconductor device as claimed in Claim 1, characterized in that the source region is constituted by a layer (14) of undoped gallium aluminium arsenide having a thickness of the order of 25 nm and by a layer (15) also of gallium aluminium arsenide having a doping concentration higher than $10^{18}$ atoms $\cdot$ cm$^{-3}$ and having a thickness of the order of 200 nm, on which a source contact (16) is formed.

10. A semiconductor device as claimed in Claim 9, characterized in that the source contact (16) is made in the form of a first layer of n-type gallium arsenide having a doping concentration between $10^{17}$ and $10^{18}$ atoms $\cdot$ cm$^{-3}$, by a second layer of n-type germanium doped with arsenic at $10^{20}$ atoms $\cdot$ cm$^{-3}$ and by a third metallic layer chosen from the group comprising gold and aluminium.


**Patentansprüche**

1. Halbleiteranordnung vom Hetero-Uebergangstransistortype mit einer Reihenfolge von Halbleiterschichten, die durch Kombination Source- (15, 14), Gate- (12) und Drain- (11, 10, 8) Gebiete bilden, während die Strecke des Stromes, der zwischen den genannten Source- und Draingebieten fliesst, im wesentlichen senkrecht auf den jeweiligen Uebergängen steht, dadurch gekennzeichnet, dass das zweite Gebiet, das Gate-Gebiet, durch eine Schicht (12) aus einem ersten Halbleitermaterial gebildet wird, die einen ersten Hetero-Uebergang mit der unmittelbar angrenzenden Schicht (11) des dritten Gebietes, des Drain-Gebietes, aus einem zweiten Halbleitermaterial bildet, während die genannten ersten und zweiten Halbleitermaterialen derart gewählt sind, dass bei dem Hetero-Uebergang die untere Kante des Leitungsbandes in dem ersten Halbleitermaterial unterhalb der unteren Kante des Leitungsbandes in dem zweiten Halbleitermaterial liegt und wobei unter dem Einfluss der Komponente des elektrischen Feldes senkrecht zu dem Hetero-Uebergang in dem zweiten Gebiet, dem Gate-Gebiet in der Nähe des Hetero-Ueberganges eine Anreicherungszone für Elektronen gebildet wird, die ein zweidimensionales quasi-Fermi-Gas bildet, in einer Potentialsenke deren unterer Pegel durch eine Gate-Elektrode (13) gesteuert wird, und dass das erste Gebiet, das Source-Gebiet, eine oder mehrere Schichten (15), von denen wenigstens diejenige, die mit der Source-Elektrode (16) kontaktiert ist, sehr stark n-dotiert ist, aus einem dritten Halbleitermaterial aufweist, das derart gewählt ist, dass die unter Kante des Leitungsbandes in dem dritten Halbleitermaterial mittels der diesem dritten Halbleitermaterial zugeführten Polarisationsspannung höher gemacht werden kann als die unter Kante des Leitungsbandes in dem zweiten Halbleitermaterial, mit dem das dritte Material einen zweiten Hetero-Uebergang bildet, und dass das genannte zweite Gebiet, das Gate-Gebiet, nicht dotiert ist und dünner ist als die mittlere freie Weglänge der Ladungsträger, derart dass das Transport der Elektronen durch dieses Gebiet hindurch durch einen ballistischen Effekt erfolgt.

2. Halbleiteranordnung nach Anspruch 1, dadurch gekennzeichnet, dass als erstes Halbleitermaterial Galliumarsenid gewählt ist, während Gallium-Aluminium-Arsenid als zweites und drittes Halbleitermaterial gewählt ist.

3. Halbleiteranordnung nach Anspruch 2, dadurch gekennzeichnet, dass das dritte Gebiet, das Drain-Gebiet, nacheinander auf einem Halbleitersubstrat (7) wenigstens eine Schicht (8) aus GaAs enthält, die sehr hoch $N^{++}$-dotiert ist mit einer Dotierungskonzentration in der Grössenordnung von $10^{18}$ Atomen $\cdot$ cm$^{-3}$ und mit einer Dicke von 0,5 μm, eine Schicht (10) aus GaAs, die niedrig n-dotiert ist mit einer Dotierungskonzentration in der Grössenordnung von $10^{16}$ Atomen $\cdot$ cm$^{-3}$ oder sogar undotiert und mit einer Dicke von etwa 0,5 μm, und eine Schicht (11) aus $Ga_{1-x}Al_xAs$, die n-dotiert ist und eine Dicke hat von etwa 100 nm.

4. Halbleiteranordnung nach Anspruch 3, dadurch gekennzeichnet, dass die Schicht (11) aus $Ga_{1-x}Al_xAs$ niedrig dotiert ist, von dem n-Leitungstyp ist und eine Dotierungskonzentration in der Grössenordnung von $10^{16}$ Atomen $\cdot$ cm$^{-3}$ aufweist.

5. Halbleiteranordnung nach Anspruch 3, dadurch gekennzeichnet, dass die Schicht (11) aus $Ga_{1-x}Al_xAs$ aus drei Zonen gebildet ist und zwar angrenzend an die obere Schicht (12), eine erste nicht dotierte Zone mit einer Dicke von etwa 5 nm und mit einer Aluminium-Fraktion x kontinuierlich variierend von etwa 0,20 bis 0,30, eine zweite hoch $n^{++}$-dotierte Zone mit einer Dotierung höher als $10^{18}$ Atomen $\cdot$ cm$^{-3}$ und mit einer Dicke von etwa 10 nm und mit einer konstanten Aluminium-Fraktion x von etwa 0,30 und zum Schluss eine dritte undotierte Zone mit einer Dicke von etwa 85 nm und mit einer konstanten Aluminium-Fraktion x von etwa 0,30 die nahezu konstant ist aber am Ende der Zone bis Null abnimmt.

6. Halbleiteranordnung nach Anspruch 3, dadurch gekennzeichnet, dass die Schicht (11) aus $Ga_{1-x}Al_xAs$ nicht dotiert ist und dass die Aluminium-Fraktion zunächst auf 0,20 liegt, dann einen Wert von 0,30 erreicht und auf diesem Pegel konstant bleibt über einen beträchtlichen Teil der Dicke, und am Ende der Zone bis Null abnimmt.

7. Halbleiteranordnung nach Anspruch 1 oder 2, dadurch gekennzeichnet, dass das zweite Gebiet, das Gate-Gebiet, durch eine Schicht (12) aus nicht dotiertem GaAs gebildet ist, während der Gate-Kontakt durch eine Schicht (13) in ohmschem Kontakt mit der genannten Schicht (12) aus nichtdotiertem GaAs erhalten wird.

8. Halbleiteranordnung nach Anspruch 7, dadurch gekennzeichnet, dass der Gate-Kontakt durch eine Schicht (13) in Form einer Goldschicht auf einer Germaniumschicht erhalten wird, die einen ohmschen Kontakt mit der genannten Schicht (12) aus nicht dotiertem GaAs bildet.

9. Halbleiteranordnung nach Anspruch 1, dadurch gekennzeichnet, dass das Source-Gebiet durch eine Schicht (14) aus nicht-dotiertem Gallium-Aluminium-Arsenid gebildet wird, die eine Dicke hat in der Grössenordnung von 25 nm und durch eine Schicht (15) ebenfalls aus Gallium-Aluminium-Arsenid mit einer Dotierungskonzentration über $10^{18}$ Atomen $\cdot$ cm$^{-3}$ und mit einer Dicke in der Grössenordnung von 200 nm, auf der ein Source-Kontakt (16) gebildet ist.

10. Halbleiteranordnung nach Anspruch 9, dadurch gekennzeichnet, dass der Source-Kontakt (16) in Form einer ersten Schicht aus n-leitendem Gallium-Arsenid gebildet ist mit einer Dotierungskonzentration zwischen $10^{17}$ und $10^{18}$ Atomen $\cdot$ cm$^{-3}$, durch eine zweite Schicht aus n-leitendem Germanium, das mit Arsen dotiert ist mit einer Dotierungskonzentration von $10^{20}$ Atomen $\cdot$ cm$^{-3}$ und durch eine dritte metallische Schicht aus Gold oder Aluminium.

FIG.1

FIG.2

FIG.3

FIG.4

FIG.5

Source

Gate

Drain

$V_1$

$E_F$

$V_2$

$V_1 = V_2$

FIG.6a

$\overrightarrow{(a)}$

$\overrightarrow{(c)}$

O

$E_{F,1}$

$\overrightarrow{(b)}$

$V_1$

$E_{F,3}$

$V_3$

17

$E_{F,2}$

$V_1 < V_3 < V_2$

FIG.6b

$V_2$

O
O

$E_{F,1}$

FIG.6c

$E_{F,2}$

4